# EUROPÄISCHE PATENTSCHRIFT

(11) **EP 0 606 642 B1**
(45) Veröffentlichungstag und Bekanntmachung des Hinweises auf die Patenterteilung: **13.03.1996**
(21) Anmeldenummer: 93120917.5
(22) Anmeldetag: 27.12.1993
(51) Int. Cl.: G03F 7/031

(54) **Lichtempfindliches Aufzeichnungselement und Verfahren zur Herstellung einer Reliefdruckplatte**
Photosensitive recording element and method for the production of a relief printing plate
Elément d'énregistrement photosensible et procédé de fabrication d'une plaque d'impression en relief

(30) Priorität: 15.01.1993 DE 4300856
(43) Veröffentlichungstag der Anmeldung: 20.07.1994
(73) Patentinhaber: BASF LACKE + FARBEN AG, D-48165 Münster (DE)
(72) Erfinder: Loerzer, Thomas, Dr., D-67435 Neustadt (DE); Telser, Thomas, Dr., D-69469 Weinheim (DE); Zwez, Thomas, Dr., D-76199 Karlsruhe (DE); Albert, Bernhard, dr., D-67133 Maxdorf (DE)
(74) Vertreter: Karau, Wolfgang, Dr.

(56) Entgegenhaltungen:
- EP-A- 0 387 578
- FR-A- 2 009 250

## Beschreibung

Die Erfindung betrifft ein lichtempfindliches Aufzeichnungselement aus
(A) einem dimensionsstabilen Träger,
(B) einer photopolymerisierbaren reliefbildenden Aufzeichnungsschicht
   sowie gegebenenfalls einer zwischen (A) und (B) angeordneten Haftschicht, einer auf der vom Träger (A) abgewandten Seite der Aufzeichnungsschicht (B) angebrachten Deckschicht (C) sowie gegebenenfalls einer darauf angebrachten Deckfolie (D), wobei die photopolymerisierbare reliefbildende Aufzeichnungsschicht (B) enthält
   b₁) mindestens ein polymeres Bindemittel,
   b₂) mindestens ein photopolymerisierbares olefinisch ungesättigtes Monomer, das mit b₁) verträglich ist,
   b₃) mindestens einen Photopolymerisationsinitiator und
   b₄) mindestens eine weitere lichtempfindliche organische Verbindung.

Die Erfindung betrifft außerdem ein neues Verfahren zur Herstellung einer Reliefdruckplatte mit klebfreier druckender Oberfläche aus einem lichtempfindlichen Aufzeichnungselement, welches einen dimensionsstabilen Träger und eine photopolymerisierbare reliefbildende Aufzeichnungsschicht enthält, die neben mindestens einem polymeren Bindemittel, mindestens einem photopolymerisierbaren olefinisch ungesättigten Monomeren und mindestens einem Photopolymerisationsinitiator noch mindestens eine weitere lichtempfindliche Verbindung enthält. Das neue Herstellverfahren umfaßt die Verfahrensschritte des bildmäßigen Belichtens der photopolymerisierbaren reliefbildenden Aufzeichnungsschicht mit aktinischem Licht, das Auswaschen (Entwickeln) der unbelichteten und daher nicht photopolymerisierten Bereiche der bildmäßig belichteten reliefbildenden Aufzeichnungsschicht mit einem Entwicklerlösungsmittel und das Nachbelichten (Nachbehandeln) der in dieser Weise erhaltenen photopolymerisierten Reliefschicht mit Licht einer Wellenlänge λ < 300 nm.

Lichtempfindliche Aufzeichnungselemente für die Herstellung von Reliefdruckplatten, welche einen dimensionsstabilen Träger und eine photopolymerisierbare reliefbildende Aufzeichnungsschicht mit mindestens einem polymeren Bindemittel, mindestens einem photopolymerisierbaren olefinisch ungesättigten Monomeren, das mit dem polymeren Bindemittel verträglich ist, mindestens einem Photopolymerisationsinitiator und mit mindestens einer weiteren lichtempfindlichen Verbindung enthalten, sind beispielsweise aus der DE-A-27 22 421, der DE-A-27 20 560 oder der DE-A-32 48 247 bekannt.

Außerdem gehen Verfahren zur Herstellung von Reliefdruckplatten mit klebfreier druckender Oberfläche, welche die eingangs genannten Verfahrensschritte umfassen, aus der DE-A-28 21 500, der EP-0 017 927 und der DE-A-39 08 059 hervor.

Bei dem in der DE-A-28 21 500 beschriebenen Herstellverfahren wird die durch bildmäßiges Belichten und Auswaschen (Entwickeln) der unbelichteten und daher nicht photopolymerisierten Bereiche der bildmäßig belichteten reliefbildenden Aufzeichnungsschicht erzeugte Reliefschicht vor dem Nachbelichten (Nachbehandeln) mit Licht einer Wellenlänge λ < 300 nm in ihrer Oberfläche mit einer wasserstoffabstrahierenden Verbindung wie 9,10-Anthrachinon imprägniert.

Bei dem Herstellverfahren, welches in der EP-B-0 017 927 beschrieben ist, wird ein lichtempfindliches Aufzeichnungsmaterial verwendet, das als wesentlichen Bestandteil ein lösungsmittellösliches Polymeres mit Polymersegmenten aus einem konjugierten Dienmonomeren in der Hauptkette sowie mindestens ein photopolymerisierbares olefinisch ungesättigtes Monomeres und einen Photopolymerisationsinitiator enthält. Wie aus Spalte 7, Zeilen 45 bis 60, dieser Patentschrift hervorgeht, können Benzophenon, Michlers Keton oder eine Reihe weiterer Verbindungen als Photopolymerisationsinitiatoren verwendet werden. Außerdem wird hierin angegeben, daß die hier genannten Photopolymerisationsinitiatoren entweder für sich allein oder in Kombination angewandt werden können. Welche Photopolymerisationsinitiatoren hierbei miteinander kombiniert werden sollen, wird indes nicht gesagt.

In der DE-A-39 08 059 wird ein Herstellverfahren beschrieben, in dem die lichtempfindliche Aufzeichnungsschicht aus mindestens einem blockcopolymeren Bindemittel, mindestens einem photopolymerisierbaren olefinisch ungesättigten Monomeren, mindestens einem Photopolymerisationsinitiator und als weitere lichtempfindliche Verbindung Benzophenon und/oder ein- oder mehrfach substituierte Benzophenone aufgebaut ist und durch bildmäßiges Belichten und Auswaschen (Entwickeln) der unbelichteten Bereiche eine Reliefschicht erzeugt wird, die durch Nachbelichten (Nachbehandeln) mit Licht einer Wellenlänge λ < 300 nm eine klebfreie Oberfläche erhält.

Diese drei bekannten Verfahren weisen indes Nachteile auf. Entweder erfordern sie einen zusätzlichen Behandlungsschritt, z.B. das Imprägnieren der Oberfläche der photopolymerisierten Reliefschicht mit 9,10-Anthrachinon, oder sie sind auf lichtempfindliche Aufzeichnungselemente mit photopolymerisierbaren reliefbildenden Aufzeichnungsschichten spezieller Zusammensetzung beschränkt und führen bei anderen lichtempfindlichen Aufzeichnungselementen nicht zu dem gewünschten Verfahrenserfolg, nämlich der Erzeugung einer klebfreien druckenden Oberfläche. Auch die Herstellung einer Reliefschicht gemäß DE-A-39 08 059 besitzt einen großen Nachteil, da Benzophenon und die genannten Derivate im aktinischen Bereich eine ähnlich hohe Absorption wie die verwendeten Photopolymerisationsinitiatoren aufweisen und dadurch die Belichtungszeiten stark erhöhen. Dies macht sich insbesondere dann bemerkbar, wenn man hohe Reliefhöhen von mehr als 1 mm, insbesondere von mehr als 3 mm erhalten will.

Aufgabe der vorliegenden Erfindung ist es, ein neues Aufzeichnungselement sowie ein neues Verfahren zur Herstellung einer Reliefdruckplatte, insbesondere einer flexographischen Reliefdruckplatte, deren photopolymerisierte Reliefschicht eine klebfreie druckende Oberfläche hat, zu finden, wobei das neue Verfahren die Verfahrensschritte
(1) bildmäßiges Belichten eines lichtempfindlichen Aufzeichnungselements, welches einen dimensionsstabilen Träger und eine photopolymerisierbare reliefbildende Aufzeichnungsschicht enthält, mit aktinischem Licht,
(2) Auswaschen (Entwickeln) der unbelichteten und daher nicht photopolymerisierten Bereiche der bildmäßig belichteten reliefbildenden Aufzeichnungsschicht mit einem Entwicklerlösungsmittel und
(3) Nachbelichten (Nachbehandeln) der in dieser Weise erhaltenen photopolymerisierten Reliefschicht mit Licht einer Wellenlänge λ < 300 nm
   umfassen und die Nachteile des Standes der Technik nicht mehr aufweisen soll.

Überraschenderweise konnte diese Aufgabe dadurch gelöst werden, daß man mindestens eine weitere lichtempfindliche Verbindung aus der Klasse der Arylalkylketone zur photopolymerisierbaren reliefbildenden Aufzeichnungsschicht des lichtempfindlichen Aufzeichnungselements hinzugibt, welches für das neue Verfahren verwendet wird. Im Hinblick auf den unerwarteten experimentellen Befund, daß Arylalkylketone für sich allein in den photopolymerisierbaren reliefbildenden Aufzeichnungsschichten bei der Belichtung mit aktinischem Licht nicht als Photopolymerisationsinitiatoren wirken, war die Lösung der erfindungsgemäßen Aufgabe um so mehr überraschend.

Gegenstand der vorliegenden Erfindung ist ein lichtempfindliches Aufzeichnungselement aus
(A) einem dimensionsstabilen Träger,
(B) einer photopolymerisierbaren reliefbildenden Aufzeichnungsschicht
   sowie gegebenenfalls einer zwischen (A) und (B) angeordneten Haftschicht, einer auf der vom Träger (A) abgewandten Seite der Aufzeichnungsschicht (B) angebrachten Deckschicht (C) sowie gegebenenfalls einer darauf angebrachten Deckfolie (D), wobei die photopolymerisierbare reliefbildende Aufzeichnungsschicht (B) enthält
   b₁) mindestens ein polymeres Bindemittel,
   b₂) mindestens ein photopolymerisierbares olefinisch ungesättigtes Monomer, das mit b₁) verträglich ist,
   b₃) mindestens einen Photopolymerisationsinitiator und
   b₄) mindestens eine weitere lichtempfindliche organische Verbindung,
      das dadurch gekennzeichnet ist, daß als lichtempfindliche organische Verbindung b₄) ein oder mehrere Arylalkylketone oder Arylbenzylketone der allgemeinen Formeln (I) und (II) 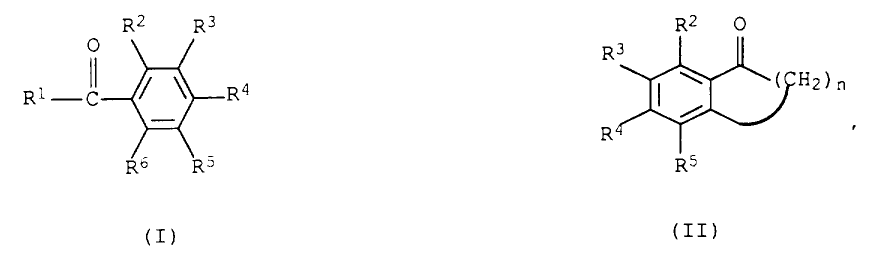 worin R¹ für
      Alkyl mit 1 bis 24 Kohlenstoffatomen,
      Alkdiyl mit 1 bis 24 Kohlenstoffatomen,
      Cycloalkyl mit 3 bis 12 Kohlenstoffatomen,
      Cycloalkdiyl mit 3 bis 12 Kohlenstoffatomen oder
      Benzyl stehen können,
      n für
      2, 3, 4, 5 oder 6 stehen kann,
      R bis R⁶ untereinander gleich oder verschieden sind und für
      H,
      Halogen,
      Hydroxy,
      Thiolo,
      Cyano,
      Alkyl mit 1 bis 24 Kohlenstoffatomen,
      Phenyl,
      Alkoxy mit 1 bis 24 Kohlenstoffatomen, Phenoxy, Alkylthio mit 1 bis 24 Kohlenstoffatomen, Phenylthio,
      Alkylcarbonyloxy mit 1 bis 24 Kohlenstoffatomen, Phenylcarbonyloxy,
      Alkylcarbonylthio mit 1 bis 24 Kohlenstoffatomen, Phenylcarbonylthio,
      Alkyloxycarbonyloxy mit 1 bis 24 Kohlenstoffatomen, Phenyloxycarbonyloxy,
      Alkyloxycarbonylthio mit 1 bis 24 Kohlenstoffatomen oder Phenyloxycarbonylthio, stehen,
         eingesetzt werden.

Bevorzugt als Arylalkylketone b₄) sind solche, die 1 bis 18 Kohlenstoffatome im Alkylrest enthalten.

Gegenstand der Erfindung ist außerdem ein Verfahren zur Herstellung einer Reliefdruckplatte mit klebfrei druckender Oberfläche, das dadurch gekennzeichnet ist, daß das erfindungsgemäße lichtempfindliche Aufzeichnungselement
(1) bildmäßig belichtet wird,
(2) die unbelichteten Bereiche der reliefbildenden Aufzeichnungsschicht (B) mit einem Entwickler entfernt werden und
(3) die so erhaltene photopolymerisierte Reliefschicht mit Licht einer Wellenlänge λ < 300 nm
   nachbehandelt wird.

Ein weiterer Gegenstand der Erfindung ist die Verwendung von Arylalkylketonen und/oder ihrer Gemische bei der Nachbehandlung der Oberfläche photopolymerer Reliefschichten mit Licht einer Wellenlänge λ < 300 nm.

Die nach dem erfindungsgemäßen Verfahren hergestellten Reliefdruckplatten weisen klebfreie druckende Oberflächen auf.

Zum erfindungsgemäßen lichtempfindlichen Aufzeichnungselement für die Herstellung von Reliefdruckplatten mit klebfreier druckender Oberfläche ist im einzelnen folgendes auszuführen.

Als dimensionsstabile Träger kommen die für die Druckplattenherstellung üblichen in Frage.

Beispiele geeigneter dimensionsstabiler Träger sind Platten, Folien und konische und zylindrische Röhren (sleeves) aus Metallen wie Stahl, Aluminium, Kupfer oder Nickel oder aus Kunststoffen wie Polyethylenterephthalat, Polybutylenterephthalat, Polyamid und Polycarbonat, Gewebe und Vliese wie Glasfasergewebe sowie Verbundmaterialien aus Glasfasern und Kunststoffen.

Auf den dimensionsstabilen Träger (A) ist, gegebenenfalls über eine dünne Haftschicht, die photopolymerisierbare reliefbildende Aufzeichnungsschicht (B) angebracht, die
b₁) mindestens ein polymeres Bindemittel,
b₂) mindestens ein photopolymerisierbares, olefinisch ungesättigtes, mit b₁) verträgliches Monomer,
b₃) mindestens einen Photoinitiator und
b₄) mindestens eine weitere lichtempfindliche organische Verbindung enthält.

Als polymere Bindemittel b₁) kommen im Prinzip alle in Betracht, wie sie üblicherweise in photopolymerisierbaren reliefbildenden Aufzeichnungsschichten verwendet werden.

Besonders gut geeignete polymere Bindemittel b₁) sind Elastomere.

Beispiele besonders gut geeigneter elastomerer polymerer Bindemittel b₁) sind die bekannten Polyalkadiene, Vinylaromat/Alkadien-Copolymerisate und -Blockpolymerisate, Alkadien/Acrylnitril-Copolymerisate, Ethylen/Propylen-Copolymerisate, Ethylen/Propylen/Alkadien-Copolymerisate, Ethylen/Acrylsäure-Copolymerisate, Alkadien/Acrylsäure-Copolymerisate, Alkadien/Acrylat/Acrylsäure-Copolymerisate und Ethylen/(Meth)Acrylsäure/(Meth)Acrylat-Copolymerisate.

Ganz besonders gut geeignet sind Elastomere, welche konjugierte Alkadiene wie Butadien oder Isopren einpolymerisiert enthalten.

Das polymere Bindemittel b₁) ist in der photopolymerisierbaren Aufzeichnungsschicht (B) in einer Menge von 50 bis 95, vorzugsweise 50 bis 90 Gew.-%, bezogen auf die Gesamtmenge der in (B) enthaltenen Komponenten enthalten.

Des weiteren enthält die erfindungsgemäß zu verwendende photopolymerisierbare reliefbildende Aufzeichnungsschicht (B) übliche und bekannte photopolymerisierbare olefinisch ungesättigte Monomere b₂), welche mit den polymeren Bindemitteln b₁) verträglich sind, in einer Menge von 1 bis 60, vorteilhafterweise von 2 bis 50, und insbesondere von 3 bis 40 Gew.-%, bezogen auf die Gesamtmenge von (B). Die Bezeichnung "verträglich" zeigt an, daß die betreffenden Monomere b₂) mit dem polymeren Bindemittel b₁) so gut abmischbar sind, daß in der betreffenden photopolymerisierbaren reliefbildenden Aufzeichnungsschicht (B) keine Trübungen oder Schlieren hervorgerufen werden. Beispiele geeigneter Monomerer b₂) sind die üblichen und bekannten Acrylate und die Methacrylate von ein- und mehrwertigen Alkoholen, Acryl- und Methacrylamide, Vinylether und Vinylester, Allylether und Allylester sowie Fumar- oder Maleinsäurediester, insbesondere die Ester der Acryl- und/ oder Methacrylsäure mit ein- und vorzugsweise mehrwertigen Alkoholen, wie z.B. Ester der Acryl- oder Methacrylsäure mit Äthandiol, Propandiol, Butandiol, Hexandiol, Oxaalkandiolen, wie z.B. Diethylenglykol, oder Ester der Acryl- oder Methacrylsäure mit drei- und mehrwertigen Alkoholen, wie z.B. Glycerin, Trimethylolpropan, Pentaerythrit oder Sorbit. Beispiele für besonders geeignete mono- und polyfunktionelle Acrylate oder Methacrylate sind Butylacrylat, Butylmethacrylat, 2-Ethylhexylacrylat, Lauryl(meth)acrylat, Hexandioldiacrylat, Hexandioldimethacrylat, Ethylenglykol-di(meth)acrylat, Butandiol-1,4-di(meth)acrylat, Neopentylglykol-di(meth)acrylat, 3-Methylpentandiol-di(meth)acrylat, 2-Hydroxipropyl(meth)acrylat, 2-Hydroxiethyl(meth)acrylat, 1,1,1-Trimethylolpropantri(meth)acrylat, Di-, Tri- und Tetraethylenglykoldi(meth)acrylat, Tripropylenglykoldi(meth)acrylat oder Pentaerythrit-tetra(meth)acrylat, des weiteren Poly(ethylenoxid)di(meth)acrylat, ω-Methylpoly(ethylenoxid)-α-yl-(meth)acrylat, N,N-Diethylaminoethylacrylat, ein Umsetzungsprodukt aus 1 mol Glycerin, 1 mol Epichlorhydrin und 3 Mol Acrylsäure sowie Glycidylmethacrylat und Bisphenol-A-diglycidetheracrylat.

Es eignen sich auch Gemische photopolymerisierbarer ethylenisch ungesättigter organischer Verbindungen, sowie z.B. Gemische monofunktioneller (Meth)acrylate, wie z.B. Hydroxiethylmethacrylat mit polyfunktionellen (Meth)acrylaten der oben angeführten Art.

Außer den (Meth)acrylsäureestern eignen sich als Komponente b₂) auch Derivate von (Meth)acrylsäureamiden, wie z.B. N-Methylol(meth)acrylamidether von Polyolen (z.B. Glykol), insbesondere wenn Polyamide oder Polyvinylalkohol als Komponente b₁) eingesetzt werden.

Als Photopolymerisationsinitiatoren b₃) kommen die für lichtempfindliche Aufzeichnungsmaterialien allgemein üblichen in Frage, beispielsweise radikalliefernde Photoinitiatoren, wie z.B. Benzoin oder Benzoinderivate, wie Benzoinether geradkettiger oder verzweigter Monoalkohole mit 1 bis 6 Kohlenstoffatomen, z.B. Benzoinmethyl-, -ethyl-, -isopropyl-, -n-butyl-, -isobutylether, symmetrisch oder unsymmetrisch substituierte Benzilacetale, wie Benzildimethylacetal, Benzil-1-methyl-1-ethylacetal, Diarylphosphinoxide, wie z.B. 2,4,6-Trimethylbenzoyldiphenylphosphinoxid oder 2,6-Dimethoxybenzoyldiphenylphosphinoxid oder Acyldiarylphosphinoxide gemäß DE-OS 29 09 992, oder Hydroxipropanone wie 1-Phenyl-2-methyl-2-hydroxi-1-propanon und 1-Hydroxicyclohexylphenylketon. Sie können allein oder im Gemisch miteinander oder in Verbindung mit Coinitiatoren verwendet werden, z.B. Benzoinmethylether mit Triphenylphosphin, Diacylphosphinoxide mit tertiären Aminen oder Acyldiarylphosphinoxide mit Benzildimethylacetal.

Komponente b₃) ist in der erfindungsgemäßen Aufzeichnungsschicht (B) in Mengen von 0,01 bis 10, vorzugsweise 0,5 bis 5, insbesondere 1 bis 2 Gew.-%, bezogen auf die Gesamtmenge der Komponenten b₁) bis b₄), enthalten.

Als Komponente b₄) enthält die photopolymerisierbare reliefbildende Aufzeichnungsschicht (B) ein oder mehrere Arylalkylketone oder Arylbenzylketone, und zwar in Mengen von 0,05 bis 10, vorzugsweise 0,1 bis 5, insbesondere 0,5 bis 1,5 Gew.-%, bezogen auf die Gesamtmenge der in (B) enthaltenen Komponenten.

Die Arylalkylketone oder Arylbenzylketone b₄) sind solche der allgemeinen Formeln (I) und (II) 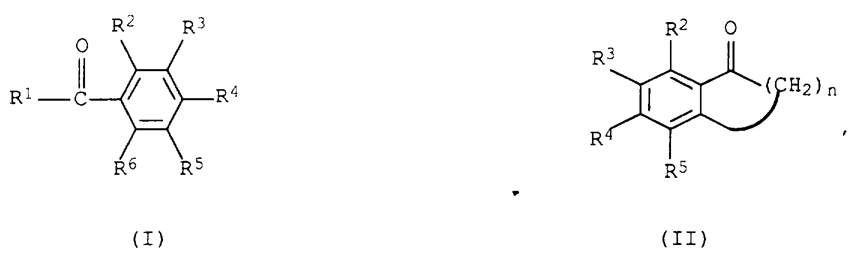 worin R¹ für
Alkyl mit 1 bis 24 Kohlenstoffatomen,
Alkdiyl mit 1 bis 24 Kohlenstoffatomen,
Cycloalkyl mit 3 bis 12 Kohlenstoffatomen,
Cycloalkdiyl mit 3 bis 12 Kohlenstoffatomen oder
Benzyl stehen können,
   n für
   2, 3, 4, 5 oder 6 stehen kann,
   R bis R⁶ untereinander gleich oder verschieden sind und für
   H,
   Halogen, z.B. Chlor,
   Hydroxy,
   Thiolo,
   Cyano,
   Alkyl mit 1 bis 24 Kohlenstoffatomen,
   Phenyl,
   Alkoxy mit 1 bis 24 Kohlenstoffatomen, Phenoxy,
   Alkylthio mit 1 bis 24 Kohlenstoffatomen, Phenylthio,
   Alkylcarbonyloxy mit 1 bis 24 Kohlenstoffatomen, Phenylcarbonyloxy,
   Alkylcarbonylthio mit 1 bis 24 Kohlenstoffatomen, Phenylcarbonylthio,
   Alkyloxycarbonyloxy mit 1 bis 24 Kohlenstoffatomen, Phenyloxycarbonyloxy,
   Alkyloxycarbonylthio mit 1 bis 24 Kohlenstoffatomen oder Phenyloxycarbonylthio, stehen.

Die Arylalkylketone bzw. Arylbenzylketone b₄) sind an sich bekannte Verbindungen, deren Herstellung im allgemeinen über Friedel-Crafts-Acylierung der entsprechenden Aromaten verläuft.

Darüber hinaus kann die erfindungsgemäß zu verwendende photopolymerisierbare reliefbildende Aufzeichnungsschicht (B) weitere Zusatzstoffe wie etwa Inhibitoren der thermisch initiierten Polymerisation, Farbstoffe, Pigmente, photochrome Stoffe, Lichthofschutzmittel, Weichmacher, Antioxidantien, Mittel zur Verbesserung der Reliefstruktur, Vernetzungshilfsmittel, Füllstoffe und/ oder Verstärkerfüllstoffe in wirksamen Mengen enthalten.

Die Herstellung der erfindungsgemäß zu verwendenden photopolymerisierbaren reliefbildenden Aufzeichnungsschicht (B) aus ihren Bestandteilen erfolgt im allgemeinen durch Mischen der Bestandteile mit Hilfe bekannter Mischmethoden und durch Verarbeiten der Mischung zur Aufzeichnungsschicht (B) mit Hilfe bekannter Techniken, wie Gießen aus Lösung, Kalandrieren oder Extrudieren, wobei diese Maßnahmen auch in geeigneter Weise miteinander kombiniert werden können.

Die Stärke der erfindungsgemäß zu verwendenden photopolymerisierbaren reliefbildenden Aufzeichnungsschicht (B) beträgt zweckmäßigerweise 200 µm bis 1 cm und insbesondere 300 µm bis 6 mm.

Das erfindungsgemäße lichtempfindliche Aufzeichnungselement kann außerdem noch weitere Schichten enthalten. So kann der dimensionsstabile Träger (A) mit einer weichelastischen Unterschicht gemäß der DE-A-24 44 118 unterlegt sein. Des weiteren kann sich auf der dem dimensionsstabilen Träger (A) abgewandten Seite der photopolymerisierbaren reliefbildenden Aufzeichnungsschicht (B) eine übliche und bekannte Deckschicht (C) und/oder eine übliche und bekannte Deckfolie (D) befinden. Werden die Deckschicht (C) und/oder eine übliche und bekannte Deckfolie (D) gemeinsam verwendet, dann liegt die Deckschicht (C) der photopolymerisierbaren reliefbildenden Aufzeichnungsschicht (B) direkt auf, und es kann sich außerdem zwischen der Deckschicht (C) und der Deckfolie (D) noch eine Antihaftschicht befinden. Ferner kann eine haftfeste Verbindung zwischen dem dimensionsstabilen Träger (A) und der photopolymerisierbaren reliefbildenden Aufzeichnungsschicht (B) mit Hilfe einer Haftlackschicht hergestellt werden.

Im allgemeinen liegt die Stärke der Haftlackschichten bei 0,5 bis 4 µm, die Stärke der Deckschichten (C) bei 0,5 bis 20 µm, die Stärke der Deckfolien (D) bei 20 bis 250 µm und die Stärke der Antihaftschicht bei 0,1 bis 0,5 µm.

Die Herstellung des erfindungsgemäßen Aufzeichnungselements weist keine methodischen Besonderheiten auf, sondern erfolgt durch Auftragen der erfindungsgemäß zu verwendenden photopolymerisierbaren reliefbildenden Aufzeichnungsschicht (B) auf den dimensionsstabilen Träger (A) mittels Gießen aus Lösung, Heißpressen, Kalandrieren oder Extrudieren. Auf dieses Zweischichtenelement können dann die anderen Schichten in bekannter Weise aufgebracht werden. Es ist aber auch möglich, die erfindungsgemäß zu verwendende photopolymerisierbare, reliefbildende Aufzeichnungsschicht (B) zunächst auf die mit einer Deckschicht (C) bedeckten Seite einer Deckfolie (D) aufzutragen und im Anschluß daran die unbedeckte Seite der photopolymerisierbaren reliefbildenden Aufzeichnungsschicht (B) mit dem dimensionsstabilen Träger (A) haftfest zu verbinden.

Bei dem erfindungsgemäßen Verfahren wird das erfindungsgemäße Aufzeichnungselement im Verfahrensschritt (1) mit aktinischem Licht bildmäßig belichtet. Beispiele geeigneter Lichtquellen für aktinisches Licht sind die üblichen und bekannten Quecksilberhoch-, -mittel- oder -niederdruckstrahler, UV-Fluoreszenzröhren oder mit Metallhalogeniden dotierten Lampen.

Im Anschluß daran werden die unbelichteten und daher nicht photopolymerisierten Bereiche der bildmäßig belichteten reliefbildenden Aufzeichnungsschicht (C) mit einem geeigneten Entwicklerlösungsmittel ausgewaschen bzw. entwickelt. Beispiele geeigneter Entwicklungslösungsmittel sind die üblichen und bekannten unpolaren, aprotisch polaren und protisch polaren Lösungsmittel sowie deren Gemische, wie sie üblicherweise für diesen Zweck verwendet werden. Im allgemeinen wird der Verfahrensschritt (2) in den üblichen und bekannten Sprüh-, Reibe- und Bürstenwaschern durchgeführt.

Im Anschluß an den Verfahrensschritt (2) wird die hierbei resultierende photopolymerisierte Reliefschicht mit Licht einer Wellenlänge λ < 300 nm, insbesondere 200 bis 300 nm, nachbelichtet bzw. nachbehandelt.

Beispiele geeigneter Lichtquellen für Licht dieser Wellenlänge sind die üblichen und bekannten Entkeimungs- bzw. Sterilisationslampen.

Das erfindungsgemäße Verfahren kann weitere Verfahrensschritte umfassen. Beispiele geeigneter weiterer Verfahrensschritte sind
- das vollflächige Vorbelichten des erfindungsgemäßen Aufzeichnungsträgers mit aktinischem Licht von seiner Vorder- und/oder Rückseite her,
- das Abziehen der gegebenenfalls in dem erfindungsgemäßen Aufzeichnungselement vorhandenen Deckfolie (D),
- das separate Auswaschen der gegebenenfalls in dem bildmäßig belichteten Aufzeichnungselement vorhandenen Deckschicht (C),
- das Trocknen und/oder das Ruhenlassen der photopolymerisierten Reliefschicht vor der Durchführung des Verfahrensschrittes (3) und
- das vollflächige Nachbelichten der photopolymerisierten Reliefschicht mit Licht einer Wellenlänge λ > 300 nm vor und/oder nach dem Verfahrensschritt (3).

Das erfindungsgemäße Verfahren weist zahlreiche besondere Vorteile auf.

So kann das erfindungsgemäße Verfahren nicht nur zur Herstellung von Reliefdruckplatten mit klebfreier druckender Oberfläche verwendet werden, sondern auch für die Herstellung von klebfreien dekorativen Reliefformen. Indes sind die besonderen Vorteile des erfindungsgemäßen Verfahrens für die Herstellung von flexographischen Reliefdruckplatten von ganz herausragender Bedeutung, weil sich bei diesem Verwendungszweck die Oberflächenklebrigkeit ganz besonders störend bemerkbar macht. Hier liefert das erfindungsgemäße Verfahren flexographische Reliefdruckplatten, deren elastomere photopolymerisierte Reliefschicht eine klebfreie drukkende Oberfläche hat. Bedingt durch die stoffliche Zusammensetzung des erfindungsgemäßen Aufzeichnungsmaterials bzw. seiner photopolymerisierbaren reliefbildenden Aufzeichnungsschicht (B) sind die Zeiten für das bildmäßige Belichten der photopolymerisierbaren reliefbildenden Aufzeichnungsschicht (B) und die Nachbelichtung mit Licht einer Wellenlänge λ < 300 nm bei dem erfindungsgemäßen Verfahren geringer als bei den Verfahren des Standes der Technik, was für die betriebliche Praxis ein bedeutungsvoller Fortschritt ist. Des weiteren zeigen die erhaltenen Reliefschichten eine wesentlich bessere Versockelung von feinen Reliefteilen, wie i-Punkten und Linien, was gerade bei großen Relieftiefen von mehr als 1 mm, insbesondere 3 und mehr mm, äußerst wichtig ist. Außerdem neigen die in erfindungsgemäßer Verfahrensweise weise hergestellten flexographischen Reliefdruckplatten bzw. deren photopolymerisierten Reliefschichten nicht zur Versprödung und zur Rißbildung bei der Nachbehandlung oder bei längerer Lagerung und/oder Dauergebrauch. Daher sind die in erfindungsgemäßer Verfahrensweise hergestellten flexographischen Reliefdruckplatten erheblich öfter und länger im Flexodruck verwendbar als die nach den Verfahren des Standes der Technik hergestellten und liefern demnach auch eine sehr viel höhere Auflage an ausgezeichneten Drucken. Hinzu kommt noch, daß die in erfindungsgemäßer Verfahrensweise hergestellten flexographischen Reliefdruckplatten eine vorzügliche Farbannahme aufweisen, dabei aber gegenüber den Druckfarbenlösungsmitteln ausgesprochen stabil sind und von diesen nicht in einem störenden Ausmaß angequollen werden.

Für die nachfolgend beschriebenen Beispiele 1 bis 20 und die Vergleichsbeispiele V1 bis V4 wurden photopolymerisierbare reliefbildende Aufzeichnungsschichten (B) der in der Tabelle angegebenen Zusammensetzung verwendet. Hierbei wurden in allen Fällen
- als polymeres Bindemittel b₁) ein übliches und bekanntes thermoplastisches elastomeres Styrol/Isopren/Styrol-Dreiblock-polymerisat (z.B. Cariflex® TR 1107 der Fa. SHELL),
- als photopolymerisierbares olefinisch ungesättigtes Monomeres b₂) 5 Gew.-% Hexan-1,6-diol-diacrylat,
- als Photopolymerisationsinitiator b₃) 1,2 Gew.-% Benzildimethylketal,
- als Hilfsstoffe 1,2 Gew.-% 2,6-Di-tert.-butyl-p-kresol, 0,002 Gew.-% des Farbstoffs Solvent Black 3 und 13 Gew.-% eines üblichen und bekannten Paraffinöls als Weichmacher

verwendet. Die Gew.-% sind auf die Gesamtmenge der in der photopolymerisierbaren reliefbildenden Aufzeichnungsschicht (B) vorhandenen Komponenten b₁) bis b₄) bezogen.

Bei den Beispielen und Vergleichsversuchen wurde für die bildmäßige Belichtung mit aktinischem Licht (Verfahrensschritt (1)) ein übliches und bekanntes Standardnegativ und ein üblicher und bekannter Röhrenflachbelichter verwendet.

Die Entwicklung der bildmäßig belichteten reliefbildenden Aufzeichnungsschichten (B) (Verfahrensschritt (2)) wurde in einem üblichen und bekannten Bürstenrundwascher durchgeführt. Hierbei wurde als Entwicklungslösungsmittel ein Gemisch aus 80 Vol.-% einer hochsiedenden hydrierten Erdölfraktion (Exxsol® D60 von ESSO) und 20 Vol.-% n-Pentanol verwendet.

Für die Nachbelichtung (Nachbehandlung) mit Licht einer Wellenlänge λ < 300 nm (Verfahrensschritt (3)) wurde eine Lampennachbehandlungsanlage von Anderson und Vreeland, Größe 300 x 400 mm, Röhrentyp: Philips TUV 40 W verwendet.

Die Klebrigkeit der druckenden Oberfläche der photopolymerisierten Reliefschichten der flexographischen Reliefdruckplatten wurde mit Hilfe der Pendelmethode nach Erichsen ermittelt. Hierzu wurden aus den photopolymerisierten Reliefschichten Volltonflächen herausgeschnitten und an diesen Proben die Pendelklebrigkeitswerte (= PKW) bestimmt. Hierbei wird bekanntermaßen ein mit einem Pendel verbundener Zylinder auf die betreffende Oberfläche aufgelegt und nach einer bestimmten Auslenkung des Pendels die Zahl der Schwingungen bis zum Stillstand des Pendels gemessen. Je klebriger die betreffende Oberfläche ist, um so stärker wird die Schwingung des Pendels gedämpft und um so geringere Pendelklebrigkeitswerte werden erhalten.

### Beispiele 1 bis 20 und Vergleichsversuche V1 bis V4

Die Herstellung flexographischer Reliefdruckplatten in erfindungsgemäßer (Beispiele 1 bis 20) und in nicht erfindungsgemäßer (Vergleichsversuche V1 bis V4) Verfahrensweise:

Die für die Durchführung der Beispiele 1 bis 20 und der Vergleichsbeispiele V1 bis V4 verwendeten lichtempfindlichen Aufzeichnungselemente hatten eine Gesamtstärke von jeweils 4700 µm und bestanden jeweils aus einer 4560 µm starken photopolymerisierbaren reliefbildenden Aufzeichnungsschicht (B) und einer 125 µm starken, mit einem Polyurethanhaftlack beschichteten Polyethylenterephthalatfolie als dimensionsstabilem Träger (A). Die Vorbelichtungszeit wurde in allen Fällen so gewählt, daß sich eine Reliefhöhe von 3 mm ergab. Bei der bildmäßigen Belichtung wurde die Zeit als Belichtungszeit gewählt, bei der der i-Punkt mit einem Durchmesser von 750 µm gut versockelt war, d.h. daß die Flanken auf keinen Fall unterschnitten sein durften, sondern im Gegenteil flach ausliefen.

Die Tabelle gibt die stoffliche Zusammensetzung bezüglich des polymeren Bindemittels b₁) und der weiteren lichtempfindlichen Verbindung b₄) an sowie die Verfahrensbedingungen, welche bei der weiteren Verarbeitung der lichtempfindlichen Aufzeichnungselemente angewandt wurden, wieder. In der letzten Spalte sind die mit Hilfe der Pendelmethode erhaltenen Pendelklebrigkeitswerte angegeben.

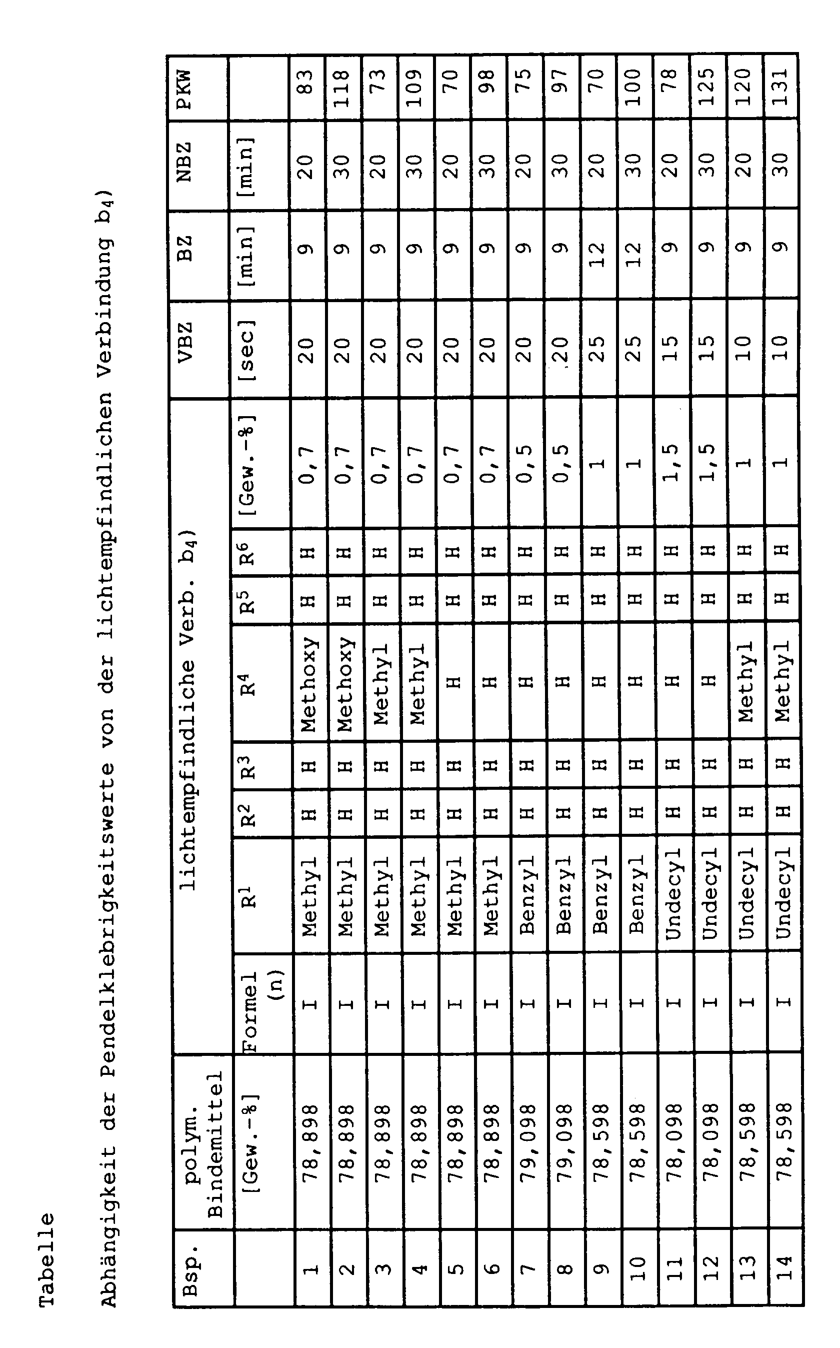

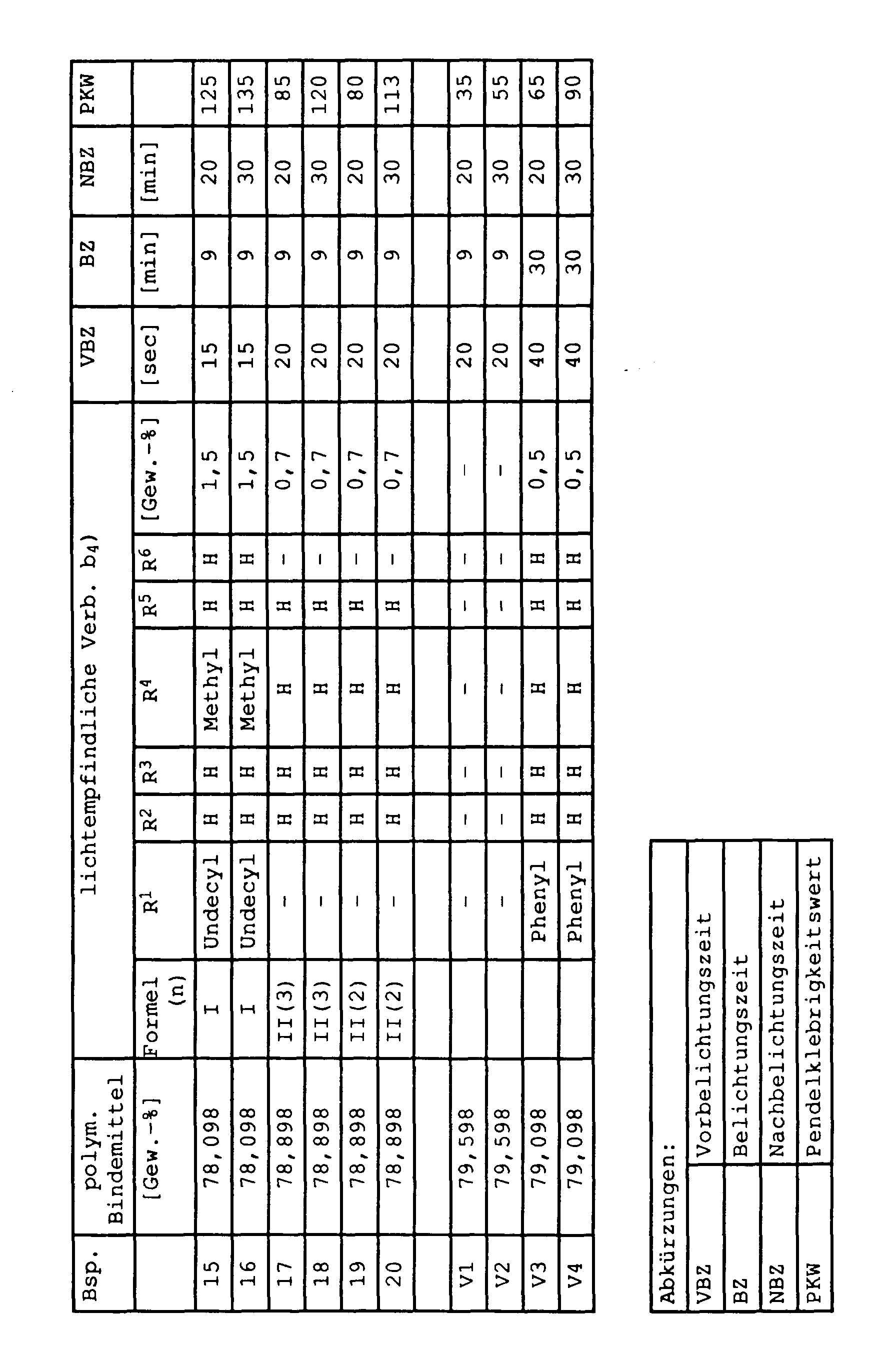

## Patentansprüche

1. Lichtempfindliches Aufzeichnungselement aus
(A) einem dimensionsstabilen Träger,
(B) einer photopolymerisierbaren reliefbildenden Aufzeichnungsschicht
sowie gegebenenfalls einer zwischen (A) und (B) angeordneten Haftschicht, einer auf der vom Träger (A) abgewandten Seite der Aufzeichnungsschicht (B) angebrachten Deckschicht (C) sowie gegebenenfalls einer darauf angebrachten Deckfolie (D), wobei die photopolymerisierbare reliefbildende Aufzeichnungsschicht (B) enthält
b₁) mindestens ein polymeres Bindemittel,
b₂) mindestens ein photopolymerisierbares olefinisch ungesättigtes Monomer, das mit b₁) verträglich ist,
b₃) mindestens einen Photopolymerisationsinitiator und
b₄) mindestens eine weitere lichtempfindliche organische Verbindung,
dadurch gekennzeichnet, daß als lichtempfindliche organische Verbindung b₄) ein oder mehrere Arylalkylketone oder Arylbenzylketone der allgemeinen Formeln (I) und (II) 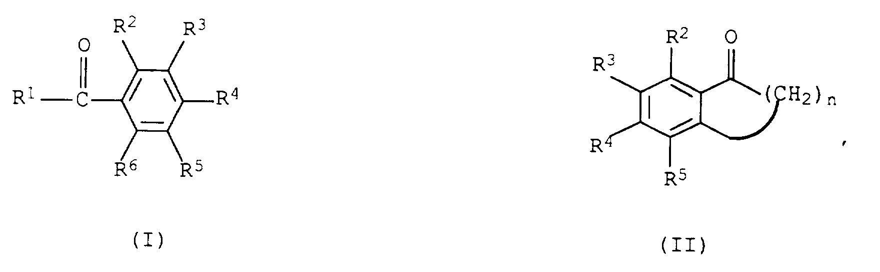 worin R¹ für
Alkyl mit 1 bis 24 Kohlenstoffatomen,
Alkdiyl mit 1 bis 24 Kohlenstoffatomen,
Cycloalkyl mit 3 bis 12 Kohlenstoffatomen,
Cycloalkdiyl mit 3 bis 12 Kohlenstoffatomen oder
Benzyl stehen können,
n für
2, 3, 4, 5 oder 6 stehen kann, R bis R⁶ untereinander gleich oder verschieden sind und für
H,
Halogen,
Hydroxy,
Thiolo,
Cyano,
Alkyl mit 1 bis 24 Kohlenstoffatomen,
Phenyl,
Alkoxy mit 1 bis 24 Kohlenstoffatomen, Phenoxy, Alkylthio
mit 1 bis 24 Kohlenstoffatomen, Phenylthio, Alkylcarbonyloxy mit 1 bis 24 Kohlenstoffatomen, Phenylcarbonyloxy,
Alkylcarbonylthio mit 1 bis 24 Kohlenstoffatomen, Phenylcarbonylthio,
Alkyloxycarbonyloxy mit 1 bis 24 Kohlenstoffatomen, Phenyloxycarbonyloxy,
Alkyloxycarbonylthio mit 1 bis 24 Kohlenstoffatomen oder
Phenyloxycarbonylthio, stehen,
eingesetzt werden.

2. Lichtempfindliches Aufzeichnungselement nach Anspruch 1, dadurch gekennzeichnet, daß als Arylalkylketon (b₄) eines mit 1 bis 18 Kohlenstoffatomen im Alkylrest eingesetzt wird.

3. Verfahren zur Herstellung einer Reliefdruckplatte mit klebfrei druckender Oberfläche, dadurch gekennzeichnet, daß ein lichtempfindliches Aufzeichnungselement gemäß Anspruch 1
(1) bildmäßig belichtet wird,
(2) die unbelichteten Bereiche der reliefbildenden Aufzeichnungsschicht (B) mit einem Entwickler entfernt werden und
(3) die so erhaltene photopolymerisierte Reliefschicht mit Licht einer Wellenlänge λ < 300 nm nachbehandelt wird.

4. Verwendung von Arylalkylketonen oder Arylbenzylketonen für die Nachbehandlung der Oberfläche photopolymerisierter Reliefschichten mit Licht einer Wellenlänge λ < 300 nm.

## Claims

1. A photosensitive recording element comprising
(A) a dimensionally stable substrate,
(B) a photopolymerizable relief-forming recording layer and, if required, an adhesion-promoting layer arranged between (A) and (B), a release layer (C) applied to that side of the recording layer (B) which faces away from the substrate (A), and, if required, a cover sheet (D) applied thereon, the photopolymerizable relief-forming recording layer (B) containing
b₁) at least one polymeric binder,
b₂) at least one photopolymerizable olefinically unsaturated monomer which is compatible with b₁),
b₃) at least one photopolymerization initiator and
b₄) at least one further photosensitive organic compound,
wherein one or more aryl alkyl ketones or aryl benzyl ketones of the formula (I) or (II) 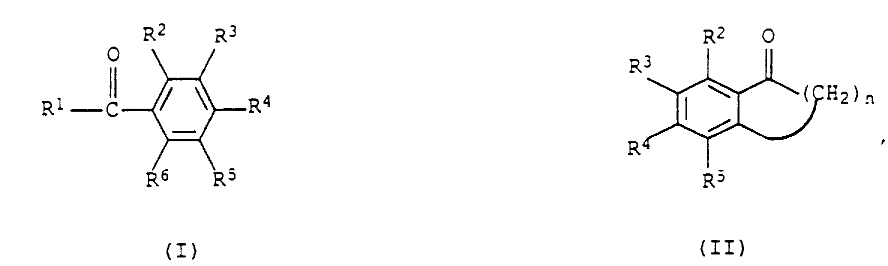
where R¹ is
alkyl of 1 to 24 carbon atoms,
alkdiyl of 1 to 24 carbon atoms,
cycloalkyl of 3 to 12 carbon atoms,
cycloalkdiyl of 3 to 12 carbon atoms or
benzyl,
n is
2,3,4, 5 or 6,
R to R⁶ are identical or different and are
H,
halogen,
hydroxyl,
thiolo,
cyano,
alkyl of 1 to 24 carbon atoms,
phenyl,
alkoxy of 1 to 24 carbon atoms, phenoxy, alkylthio of 1 to 24 carbon atoms, phenylthio,
alkylcarbonyloxy of 1 to 24 carbon atoms, phenylcarbonyloxy,
alkylcarbonylthio of 1 to 24 carbon atoms, phenylcarbonylthio,
alkoxycarbonyloxy of 1 to 24 carbon atoms, phenoxycarbonyloxy,
alkoxycarbonylthio of 1 to 24 carbon atoms or phenoxycarbonylthio,
are used as the photosensitive organic compound b₄).

2. A photosensitive recording element as claimed in claim 1, wherein the aryl alkyl ketone (b₄) used is one in which the alkyl radical is of 1 to 18 carbon atoms.

3. A process for the production of a relief printing plate having a nontacky printing surface, wherein a photosensitive recording element as claimed in claim 1
(1) is exposed imagewise,
(2) the unexposed parts of the relief-forming recording layer (B) are removed by means of a developer and
(3) the photopolymerized relief layer thus obtained is aftertreated with light having a wavelength λ of < 300 nm.
4. Use of an aryl alkyl ketone or an aryl benzyl ketone for the aftertreatment of the surface of photopolymerized relief layers with light having a wavelength λ of < 300 nm.

## Revendications

1. Elément d'enregistrement photosensible à base de
(A) un support stable en dimensions,
(B) une couche d'enregistrement formant un relief, photopolymérisable,
ainsi qu'éventuellement une couche de fixation disposée entre (A) et (B), une couche de recouvrement (C) disposée sur la face opposée au support (A) de la couche d'enregistrement (B), ainsi qu'éventuellement une feuille de recouvrement (D) disposée au-dessus, tandis que la couche d'enregistrement (B) formant un relief, photopolymérisable, contient
b₁) au moins un liant polymère,
b₂) au moins un monomère photopolymérisable, à insaturation oléfinique, qui est compatible avec b₁),
b₃) au moins un initiateur de photopolymérisation et
b₄) au moins un autre composé organique photosensible,
caractérisé en ce qu'on utilise, comme composé organique photosensible b₄), une ou plusieurs arylalkylcétones ou arylbenzylcétones de formules générales (I) et (II) 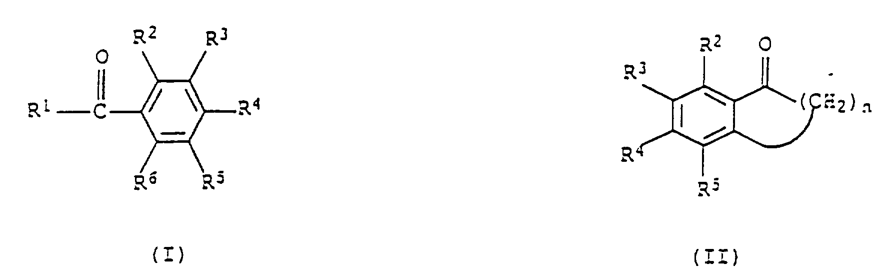
où R¹ peut désigner un groupe
alkyle ayant 1 à 24 atomes de carbone,
alcanediyle ayant 1 à 24 atomes de carbone,
cycloalkyle ayant 3 à 12 atomes de carbone, cycloalcanediyle ayant 3 à 12 atomes de carbone ou benzyle,
n peut être 2, 3, 4, 5 ou 6,
R à R⁶ sont identiques entre eux ou différents et désignent
H,
halogène,
hydroxy,
thiolo,
cyano,
alkyle ayant 1 à 24 atomes de carbone,
phényle,
alcoxy ayant 1 à 24 atomes de carbone, phénoxy,
alkylthio ayant 1 à 24 atomes de carbone, phénylthio,
alkylcarbonyloxy ayant 1 à 24 atomes de carbone, phénylcarbonyloxy,
alkylcarbonylthio ayant 1 à 24 atomes de carbone, phénylcarbonylthio,
alkyloxycarbonyloxy ayant 1 à 24 atomes de carbone, phényloxycarbonyloxy,
alkyloxycarbonylthio ayant 1 à 24 atomes de carbone ou phényloxycarbonylthio.

2. Elément d'enregistrement photosensible selon la revendication 1, caractérisé en ce qu'on emploie, comme arylalkylcétone (b₄), un tel composé ayant 1 à 18 atomes de carbone dans le reste alkyle.

3. Procédé pour la préparation d'une plaque d'impression en relief avec surface d'impression non collante, caractérisé en ce que
(1) on éclaire selon une image un élément d'enregistrement photosensible selon la revendication 1,
(2) on élimine les zones non éclairées de la couche d'enregistrement formant un relief (B) avec un développateur et
(3) on traite ensuite la couche de relief photopolymérisée ainsi obtenue avec de la lumière ayant une longueur d'onde λ < 300 nm.

4. Utilisation d'arylalkylcétones ou d'arylbenzylcétones pour le post-traitement de la surface de couches en relief photopolymérisées avec de la lumière ayant une longueur d'onde λ < 300 nm.
